# FASCICULE DE BREVET EUROPEEN

(11) **EP 3 667 715 B1**
(45) Date de publication et mention de la délivrance du brevet: **30.06.2021**
(21) Numéro de dépôt: 19215108.2
(22) Date de dépôt: 11.12.2019
(51) Int. Cl.: H01L 21/84, H01L 21/8234, H01L 29/78, H01L 21/8238

(54) **PROCEDE DE REALISATION D'UN SUBSTRAT SEMI-CONDUCTEUR COMPRENANT UNE REGION DE SEMI-CONDUCTEUR CONTRAINT**
VERFAHREN ZUR HERSTELLUNG EINES HALBLEITERSUBSTRATES MIT EINEM VERSPANNTEN HALBLEITERGEBIET
METHOD FOR PRODUCING A SEMICONDUCTOR SUBSTRATE COMPRISING A STRAINED SEMICONDUCTOR REGION

(30) Priorité: 12.12.2018 FR 1872765
(43) Date de publication de la demande: 17.06.2020
(73) Titulaire: Commissariat à l'énergie atomique et aux énergies alternatives, 75015 Paris (FR)
(72) Inventeur: REBOH, Shay, 38054 GRENOBLE Cedex 09 (FR); BOUREAU, Victor, 38054 GRENOBLE CEDEX 09 (FR); MAITREJEAN, Sylvain, 38054 GRENOBLE CEDEX 09 (FR); ANDRIEU, François, 38054 GRENOBLE CEDEX 09 (FR)
(74) Mandataire: Brevalex

(56) Documents cités:
- US-A1- 2017 194 498
- IRISAWA ET AL: "High-Performance Uniaxially Strained SiGe-on-Insulator pMOSFETs Fabricated by Lateral-Strain-Relaxation Technique", IEEE TRANSACTIONS ON ELECTRON DEVICES, IEEE SERVICE CENTER, PISACATAWAY, NJ, US, vol. 53, no. 11, 1 novembre 2006 (2006-11-01), pages 2809-2815, XP011142529, ISSN: 0018-9383, DOI: 10.1109/TED.2006.884078

## Description

### DOMAINE TECHNIQUE ET ART ANTÉRIEUR

L'invention concerne le domaine des substrats semi-conducteurs adaptés à la réalisation de dispositifs semi-conducteurs tels que des transistors, et comprenant au moins une région de semi-conducteur contraint en compression ou en tension adaptée à la réalisation de zones actives des dispositifs semi-conducteurs. Un tel substrat permet avantageusement la réalisation, dans la région de semi-conducteur contraint, de transistors FET (« Field Effect Transistor », ou transistor à effet de champ) de type P lorsque le semi-conducteur est contraint en compression, ou de transistors FET de type N lorsque le semi-conducteur est contraint en tension. Un tel substrat permet en outre l'intégration, sur une même couche semi-conductrice, de transistors FET de types différents et/ou dont les canaux sont formés dans des régions de semi-conducteur soumises à des contraintes différentes, par exemple des transistors FET de type P ayant des canaux contraints en compression et d'autres transistors FET, par exemple de type N et ayant des canaux non contraints en compression ou contraints en tension, ou bien d'autres transistors de type P ayant des canaux contraints en compression ou non contraints en compression.

Un matériau cristallin déformé mécaniquement correspond à un matériau qui a son ou ses paramètre(s) de maille cristalline allongé(s) ou écourté(s). Dans le cas où le paramètre de maille déformé est plus important que le paramètre dit « naturel » du matériau cristallin, celui-ci est dit en déformation en tension. Lorsque le paramètre de maille déformé est plus petit que le paramètre de maille naturel, le matériau est dit en déformation compressive ou en compression.

A ces états de déformation mécanique d'un matériau cristallin, on associe des états de contraintes mécaniques. Pour autant, il est également commun de se référer à ces états de déformation comme des états de contraintes mécaniques. Dans la présente demande, cette notion de déformation (« strain » en anglais) est désignée de façon générique par le terme « contrainte ».

Afin d'améliorer les performances d'un transistor, celui-ci peut être réalisé avec un canal contraint, c'est-à-dire dont le semi-conducteur formant le canal comporte une contrainte, ou est soumis à une contrainte.

Dans un transistor FET de type P, une contrainte compressive, ou contrainte en compression, du canal permet d'améliorer la mobilité des porteurs de charges (trous) dans le canal. Dans un transistor FET de type N, c'est une contrainte en tension du canal qui permet d'améliorer la mobilité des porteurs de charges (électrons) dans le canal.

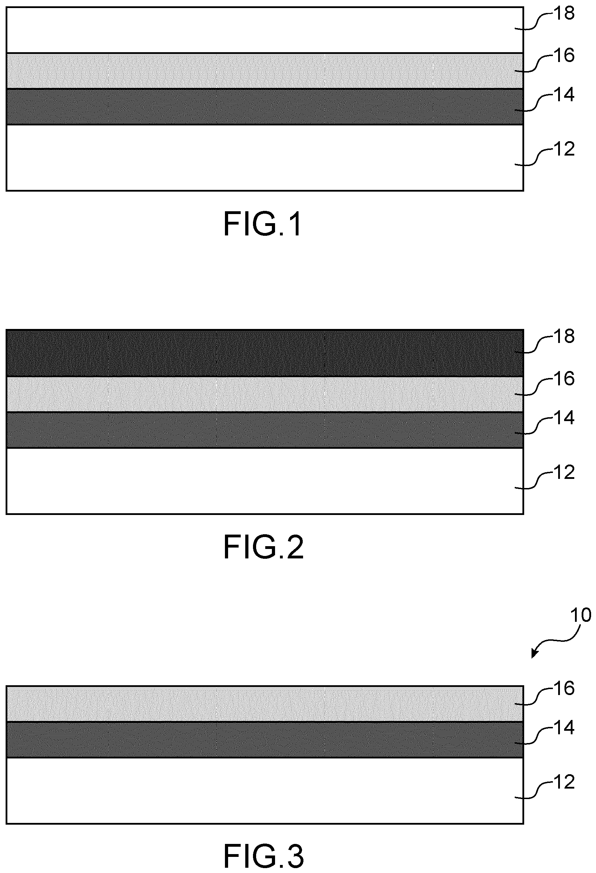

Pour réaliser un transistor FET de type P avec un canal contraint en compression, il est possible d'utiliser un substrat comprenant une couche active (couche dans laquelle la zone active du transistor est réalisée) de SiGe contraint en compression. Un exemple de réalisation d'un tel substrat 10 est décrit en lien avec les figures 1 à 5.

Le substrat 10 est réalisé à partir d'un substrat de type semi-conducteur sur isolant, ici SOI (« Silicon On Insulator », ou silicium sur isolant). Le substrat SOI comporte une couche support 12, ou couche épaisse, sur laquelle se trouve une couche diélectrique enterrée 14, ou BOX (« Buried Oxide », ou oxyde enterré), comprenant par exemple du SiO₂ et dont l'épaisseur est par exemple comprise entre environ 25 nm et 200 nm, et une couche superficielle 16, ou couche mince, dont l'épaisseur est par exemple comprise entre environ 5 nm et 30 nm, comprenant ici du silicium et dans laquelle les zones actives des transistors FET sont destinées à être réalisées.

Une couche 18 de SiGe est tout d'abord formée par épitaxie sur la ou les parties de la couche superficielle 16 dans lesquelles du SiGe contraint en compression est destiné à être réalisé, par exemple dans la ou les régions de la couche superficielle 16 dans lesquelles des transistors FET de type P sont destinés à être réalisés (figure 1). Cette localisation de la couche 18 sur la ou les parties de la couche superficielle 16 souhaitées peut être obtenue en utilisant un masque, comprenant par exemple du SiN, dont la ou les ouvertures sont localisées au-dessus de cette ou ces parties de la couche superficielle 16. Sur la figure 1, la couche de SiGe 18 recouvre toute la couche superficielle 16.

Une étape d'oxydation thermique de la couche 18 de SiGe est ensuite mise en œuvre. Cette oxydation, qui est mise en œuvre à une température importante, par exemple supérieure à 850°C, entraîne une migration d'atomes de germanium issus de la couche 18 dans le silicium de la couche superficielle 16. La concentration en germanium dans la couche 16 s'homogénéise. La couche diélectrique enterrée 14 forme une barrière de diffusion au cours de cette oxydation. Cet enrichissement en germanium du silicium de la couche 16 modifie la nature du silicium de la couche 16 qui devient du SiGe contraint en compression. Sur la figure 2, la structure représentée correspond à la structure obtenue à l'issue de cette étape d'oxydation, dans laquelle la couche 18 comporte majoritairement du SiO₂ et la couche 16 comporte du SiGe contraint en compression.

La couche d'oxyde 18 formée par l'oxydation du SiGe est ensuite retirée (figure 3). L'empilement des couches restantes 12, 14 et 16 forment ensemble un substrat 10 de type SiGeOI, ou SGOI (c'est-à-dire SiGe sur isolant), avec du SiGe contraint en compression formant la couche superficielle de ce substrat 10.

Cette technique de réalisation du SiGe contraint en compression, appelée condensation de Ge ou enrichissement de Ge, est par exemple décrite dans le document « The Ge condensation technique: A solution for planar SOI/GeOI co-integration for advanced CMOS technologies? » de B. Vincent et al., Material Science in Semiconductor Processing 11 (2008) pages 205-213.

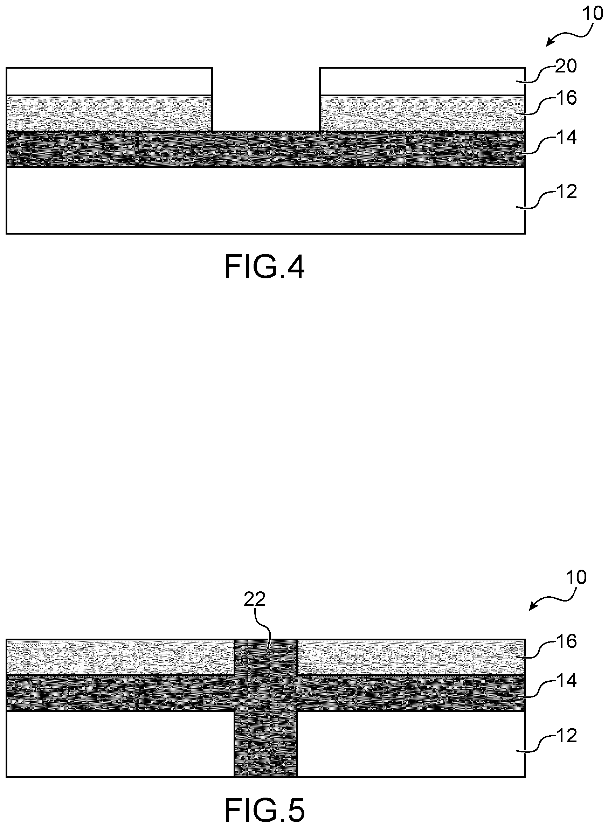

A partir d'un tel substrat 10, différentes étapes technologiques sont ensuite mises en œuvre. La réalisation de tranchées d'isolation STI (« Shallow Trench Isolation », ou tranchée d'isolation peu profonde) au sein du substrat 10 implique de graver la couche 16 pour former des régions distinctes, ou isolées, de SiGe. Ainsi, sur la figure 4, un masque de gravure 20 est déposé sur la couche 16, puis cette couche 16 est gravée conformément au motif du masque 20. Cette gravure peut être prolongée à travers la couche diélectrique enterrée 14 et également dans la couche support 12 (comme c'est le cas dans le procédé décrit ici). Une tranchée d'isolation 22 est formée en déposant un matériau diélectrique dans la tranchée gravée, puis le masque 20 est retiré (figure 5). Le substrat 10 comprenant différentes régions isolées les unes des autres par des tranchées d'isolation 22 est ainsi obtenu.

Un problème rencontré avec le procédé décrit ci-dessus est qu'après avoir réalisé la ou les tranchées d'isolation 22 et après avoir retiré le masque 20, une réduction de la contrainte en compression plus importante que celle due à la seule relaxation élastique du semi-conducteur, se produit dans le semi-conducteur contraint en compression. Les effets bénéfiques liés à cette contrainte et obtenus dans des transistors réalisés dans un tel substrat sont donc réduits.

Le document FR 3 046 492 propose un procédé dans lequel les tranchées d'isolation sont remplacées par des barres d'oxyde formées par oxydation de portions du semi-conducteur de la couche active. En évitant de graver la couche superficielle, la réduction importante de la contrainte décrite précédemment ne se produit pas. Toutefois, un tel procédé n'est pas adapté à la réalisation de tranchées d'isolation devant atteindre une certaine profondeur dans le substrat, comme par exemple lorsque les tranchées d'isolation servent à isoler des caissons entre eux afin de permettre une polarisation des caissons indépendamment les uns des autres.

### EXPOSÉ DE L'INVENTION

Un but de la présente invention est de proposer un procédé de réalisation d'un substrat semi-conducteur adapté à la réalisation de dispositifs semi-conducteurs, notamment des transistors FET, dans au moins une région de semi-conducteur contraint, dans lequel une relaxation excessive du semi-conducteur contraint est évitée lors d'une gravure du semi-conducteur contraint, et cela même lorsque cette gravure est mise en œuvre à travers la couche active comprenant le semi-conducteur contraint et au moins une partie d'une ou plusieurs couches présentes sous la couche active.

Pour cela, l'invention propose un procédé de réalisation d'un substrat semi-conducteur, comprenant au moins la mise en œuvre des étapes suivantes :
- réalisation d'une couche superficielle disposée sur une couche diélectrique enterrée et comprenant au moins une région de semi-conducteur contraint ;
- réalisation d'un masque de gravure sur la couche superficielle, recouvrant au moins une partie de la région de semi-conducteur contraint ;
- gravure de la couche superficielle selon un motif du masque de gravure, révélant au moins un premier bord latéral formé par au moins une première portion de semi-conducteur contraint appartenant à ladite partie de la région de semi-conducteur contraint et qui est en contact avec la couche diélectrique enterrée ;
- modification de la première portion de semi-conducteur contraint en au moins une deuxième portion de matériau formant un élément d'appui mécanique disposé contre la région de semi-conducteur contraint ;
- retrait du masque de gravure.

Dans ce procédé, entre l'étape de gravure de la couche superficielle et l'étape de retrait du masque de gravure, une étape de modification d'au moins une première portion du semi-conducteur contraint qui forme le ou les premiers bords latéraux révélés par la gravure et qui est en contact avec la couche diélectrique enterrée est mise en œuvre pour remplacer ou transformer le semi-conducteur contraint de cette ou ces premières portions en au moins une deuxième portion de matériau(x) différent(s) ou non du semi-conducteur contraint. Le matériau formant le ou les premiers bords latéraux et qui fait partie de l'interface couche diélectrique enterrée / couche superficielle est donc modifié.

La modification du semi-conducteur contraint de la première portion modifie l'interface initialement formée entre le semi-conducteur contraint de la première portion et le matériau de la couche diélectrique enterrée. Cette modification de cette interface permet d'obtenir la deuxième portion qui forme une barrière mécanique, ou élément d'appui mécanique, permettant au semi-conducteur contraint restant de la région de semi-conducteur contraint d'être en appui mécanique contre cette deuxième portion de matériau. En retirant le masque de gravure, une relaxation excessive du semi-conducteur contraint est ainsi évitée grâce à l'élément ou les éléments d'appui mécanique formés. La modification de l'interface entre le semi-conducteur contraint de la première portion et le matériau de la couche diélectrique enterrée est obtenue même lorsque le semi-conducteur contraint de la première portion est gravé et remplacé par un semi-conducteur contraint identique.

La relaxation excessive du semi-conducteur contraint est évitée quelle que soit la profondeur de la gravure réalisée, ce qui rend ce procédé compatible avec la réalisation de tranchées d'isolation traversant la couche active et au moins une partie d'une ou plusieurs couches présentes sous la couche active. Ce procédé est notamment bien adapté pour réaliser un substrat dans lequel des composants de type FDSOI (« Fully-Depleted Silicon On Insulator », ou silicium sur isolant totalement déserté) sont fabriqués.

Un autre avantage de ce procédé est que sa mise en œuvre ne fait pas appel à des masques de gravure nécessitant un alignement différent de ceux servant à la réalisation des tranchées d'isolation.

Un tel substrat est bien adapté pour réaliser en technologie CMOS un ou plusieurs transistors FET de type P ayant un canal contraint en compression dans la région de semi-conducteur contraint, et un ou plusieurs autres transistors FET, par exemple de type P ou N et ayant un canal contraint ou non en compression, dans une autre région du substrat.

Un tel substrat est bien adapté à la réalisation de transistors FET de type FDSOI, et/ou de transistors FET de type P comprenant un canal de SiGe contraint en compression et de transistors de type N comprenant un canal de Si ou de SiGe contraint en tension.

Un tel substrat est aussi bien adapté à la réalisation de transistors FET de type FinFET, ou à nanofils (également appelés « NW » ou « NanoWires ») ou à nanofeuilles (également « NS » ou « NSH » ou « NanoSheets »).

Le ou les premiers bords latéraux formés par la région de semi-conducteur contraint correspondent à des faces de parties de la couche superficielle révélées par la gravure de la couche superficielle et qui sont par exemple orientées sensiblement perpendiculairement aux faces principales de la couche superficielle (qui correspondent aux faces de plus grandes dimensions de la couche superficielle).

Le motif du masque de gravure correspond au dessin formé par les ouvertures traversant le masque, dans le plan principal du masque de gravure, c'est-à-dire le plan parallèle aux faces principales du masque et qui correspondent aux faces de plus grandes dimensions du masque.

La ou les deuxièmes portions peuvent comporter un seul ou plusieurs matériaux différents (en termes de nature et/ou composition chimique, de propriétés physiques et/ou chimiques, etc.) du semi-conducteur contraint. En variante, la ou les deuxièmes portions peuvent comporter un matériau identique au semi-conducteur contraint.

Dans un premier mode de réalisation, l'étape de modification de la première portion de semi-conducteur contraint peut comporter la mise en œuvre d'une réaction chimique transformant le semi-conducteur contraint.

La réaction chimique peut correspondre à une oxydation et/ou une nitruration du semi-conducteur contraint. Dans ce cas, le matériau de la deuxième portion comporte au moins un oxyde du semi-conducteur contraint et/ou un nitrure du semi-conducteur contraint.

De plus, l'étape de modification de la première portion de semi-conducteur contraint peut comporter en outre, préalablement à la mise en œuvre de la réaction chimique du semi-conducteur contraint, une étape de retrait d'une partie de la première portion de semi-conducteur contraint, et la réaction chimique peut ensuite être mise en œuvre à partir du reste de la première portion de semi-conducteur contraint.

Dans un deuxième mode de réalisation, l'étape de modification de la première portion de semi-conducteur contraint peut comporter :
- une gravure de la première portion de semi-conducteur contraint, formant au moins une cavité disposée entre la couche diélectrique enterrée et le masque de gravure, puis
- une étape de réalisation, dans la cavité, de la deuxième portion de matériau.

Le matériau de la deuxième portion peut correspondre à au moins un matériau semi-conducteur et/ou un matériau diélectrique.

Le semi-conducteur contraint peut correspondre à du SiGe contraint en compression, la couche superficielle pouvant être réalisée par enrichissement de germanium dans une couche de silicium.

En outre, le semi-conducteur contraint en compression qui correspond à du SiGe peut comporter une concentration en germanium comprise entre environ 20 % et 50 %. Il est toutefois possible que cette concentration en germanium soit comprise entre environ 20 % et 100 % (avec, dans le cas d'une concentration en germanium égale à 100 %, un semi-conducteur contraint en compression correspondant à du germanium). La concentration en germanium dans le semi-conducteur correspond ici au pourcentage atomique de germanium au sein de ce semi-conducteur.

Avant la mise en œuvre de l'enrichissement en germanium, la couche de silicium peut comporter du silicium contraint en tension. Par exemple, la couche de silicium peut correspondre à la couche superficielle d'un substrat sSOI (« strained Silicon On Insulator », ou silicium contraint sur isolant). Une partie des atomes de germanium introduits dans la couche de silicium lors de l'enrichissement en germanium servent à annuler la contrainte en tension, et les autres atomes de germanium introduits dans la couche de silicium servent à apporter la contrainte en compression.

Le motif du masque de gravure peut définir des tranchées d'isolation disposées autour de la région de semi-conducteur contraint, et le procédé peut comporter en outre, après l'étape de modification de la première portion de semi-conducteur contraint, une étape de dépôt d'au moins un matériau diélectrique dans les tranchées d'isolation.

Le procédé peut comporter en outre, entre l'étape de modification de la première portion de semi-conducteur contraint et l'étape de retrait du masque dur, la mise en œuvre d'une étape de gravure prolongeant les tranchées d'isolation à travers au moins une partie de l'épaisseur de la couche diélectrique enterrée, ou à travers la couche diélectrique enterrée et une partie de l'épaisseur d'une couche support disposée telle que la couche diélectrique enterrée soit disposée entre la couche support et la couche superficielle.

Une dimension de la première portion de semi-conducteur contraint, selon une direction sensiblement perpendiculaire au premier bord latéral, peut être comprise entre environ 3 nm et 25 nm.

L'étape de gravure de la couche superficielle grave le motif du masque de gravure à travers la couche superficielle, ou à travers la couche superficielle et au moins une partie de l'épaisseur de la couche diélectrique enterrée, ou à travers la couche superficielle, la couche diélectrique enterrée et une partie de l'épaisseur d'une couche support disposée telle que la couche diélectrique enterrée soit disposée entre la couche support et la couche superficielle.

Selon une configuration particulière, le procédé peut être tel que :
- la région de semi-conducteur contraint a, dans un plan principal de la couche superficielle, une forme sensiblement rectangulaire ;
- le motif du masque de gravure est tel que la gravure de la couche superficielle révèle au moins deux premiers bords latéraux opposés et formés par la partie de la région de semi-conducteur contraint ;
- l'étape de modification est mise en œuvre telle qu'elle modifie au moins deux premières portions de semi-conducteur contraint qui forment les deux premiers bords latéraux et qui sont en contact avec la couche diélectrique enterrée.

Dans ce cas, il est possible que lors du retrait du masque de gravure, la contrainte dans la région de semi-conducteur contraint se relaxe partiellement selon une direction parallèle aux deux premiers bords latéraux, et une relaxation excessive de la contrainte selon la direction perpendiculaire aux deux premiers bords latéraux est évitée.

Le plan principal de la couche superficielle correspond à un plan parallèle au substrat, c'est-à-dire parallèle aux faces principales de la couche superficielle qui correspondent aux faces de plus grandes dimensions de la couche superficielle.

De plus, le procédé peut être tel que :
- le motif du masque de gravure est tel que la gravure de la couche superficielle révèle en outre au moins deux deuxièmes bords latéraux opposés, formés par la partie de la région de semi-conducteur contraint et sensiblement perpendiculaires aux deux premiers bords latéraux ;
- l'étape de modification est mise en œuvre telle qu'elle modifie au moins quatre premières portions de semi-conducteur contraint qui forment les deux premiers bords latéraux et les deux deuxièmes bords latéraux et qui sont en contact avec la couche diélectrique enterrée.

Dans ce cas, lors du retrait du masque de gravure, la contrainte dans la région de semi-conducteur contraint est conservée selon les directions perpendiculaires aux premiers bords latéraux et aux deuxièmes bords latéraux, et une relaxation excessive du semi-conducteur contraint est évitée selon ces directions.

La tranchée d'isolation peut entourer la région de semi-conducteur contraint.

Le masque de gravure peut comporter au moins un matériau contraint en tension ou en compression. Un tel masque de gravure permet de modifier la contrainte dans le semi-conducteur sur lequel le masque est réalisé. Par exemple, lorsque la contrainte initiale dans le semi-conducteur contraint correspond à une contrainte en compression, un tel masque de gravure peut permettre d'obtenir un semi-conducteur non contraint, voir contraint en tension.

Le procédé peut comporter en outre, après le retrait du masque de gravure, la mise en œuvre des étapes suivantes :
- amincissement de la région de semi-conducteur contraint ;
- épitaxie d'au moins un deuxième semi-conducteur sur la région de semi-conducteur contraint amincie.

L'invention concerne également un procédé de réalisation d'au moins un transistor FET, dans lequel ledit au moins un transistor FET est réalisé dans la région de semi-conducteur contraint d'un substrat semi-conducteur obtenu par la mise en œuvre du procédé de réalisation d'un substrat décrit ci-dessus.

### BRÈVE DESCRIPTION DES DESSINS

La présente invention sera mieux comprise à la lecture de la description d'exemples de réalisation donnés à titre purement indicatif et nullement limitatif en faisant référence aux dessins annexés sur lesquels :
- les figures 1 à 5 représentent un procédé de réalisation d'un substrat semi-conducteur comprenant une couche de semi-conducteur contraint en compression ;
- les figures 6 à 10 représentent les étapes d'un procédé de réalisation d'un substrat semi-conducteur, objet de la présente invention, selon un premier mode de réalisation ;
- la figure 11 représente un substrat semi-conducteur obtenu par la mise en œuvre d'un procédé de réalisation, objet de la présente invention, selon une variante du premier mode de réalisation ;
- les figures 12 à 14 représentent des variantes de mise en œuvre du procédé de réalisation du substrat semi-conducteur, objet de la présente invention, selon le premier mode de réalisation ;
- la figure 15 représente une structure intermédiaire obtenue lors de la mise en œuvre du procédé de réalisation du substrat semi-conducteur, objet de la présente invention, selon un deuxième mode de réalisation ;
- les figures 16 et 17 représentent des structures intermédiaires obtenues lors de la mise en œuvre du procédé de réalisation du substrat semi-conducteur, objet de la présente invention, selon des variantes de réalisation ;
- la figure 18 représente un substrat semi-conducteur obtenu par la mise en œuvre d'un procédé de réalisation, objet de la présente invention, selon une variante de réalisation ;
- la figure 19 représente des transistors FET réalisés dans un substrat semi-conducteur obtenu lors de la mise en œuvre du procédé de réalisation du substrat semi-conducteur, objet de la présente invention.

Des parties identiques, similaires ou équivalentes des différentes figures décrites ci-après portent les mêmes références numériques de façon à faciliter le passage d'une figure à l'autre.

Les différentes parties représentées sur les figures ne le sont pas nécessairement selon une échelle uniforme, pour rendre les figures plus lisibles.

Les différentes possibilités (variantes et modes de réalisation) doivent être comprises comme n'étant pas exclusives les unes des autres et peuvent se combiner entre elles.

### EXPOSÉ DÉTAILLÉ DE MODES DE RÉALISATION PARTICULIERS

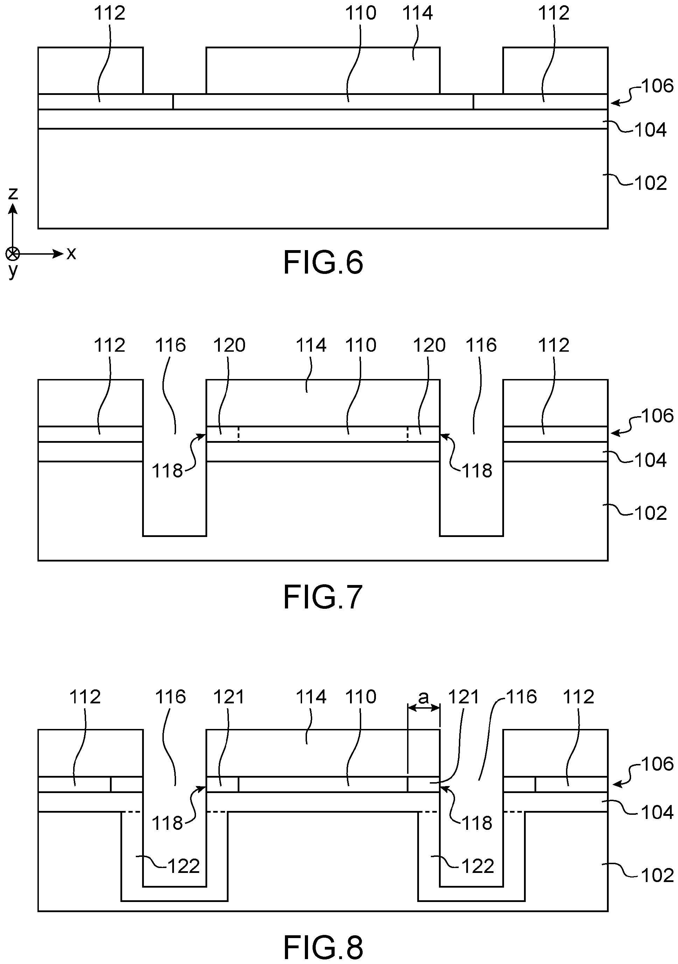

Un premier mode de réalisation d'un procédé de réalisation d'un substrat semi-conducteur 100 adapté à la réalisation de dispositifs semi-conducteurs tel qu'un ou plusieurs transistors FET dans au moins une région de semi-conducteur contraint du substrat, est représenté sur les figures 6 à 10.

Ce procédé est mis en œuvre à partir d'un substrat SOI. Le substrat SOI comporte une couche support 102, ou couche épaisse, sur laquelle se trouve une couche diélectrique enterrée 104 comprenant par exemple du SiO₂ et dont l'épaisseur est par exemple comprise entre environ 25 nm et 200 nm, et une couche superficielle 106 dont l'épaisseur est par exemple comprise entre environ 5 nm et 20 nm.

En fonction des composants électroniques à réaliser dans le substrat 100, différentes régions comprenant des matériaux soumis à différentes contraintes peuvent être réalisées dans la couche superficielle 106. Dans le premier mode de réalisation décrit ici, le substrat 100 est destiné à comporter des transistors FET de type P dont les zones actives sont réalisées dans des régions de semi-conducteur contraint en compression, et des transistors FET de type N dont les zones actives sont réalisées dans des régions de semi-conducteur non contraint. Pour cela, la couche superficielle 106 comporte des premières régions 110 de SiGe contraint en compression et des deuxièmes régions 112 de SiGe non contraint ou de Si non contraint. Sur les figures 6 à 10, une première région 110 entourée de deuxièmes régions 112 sont représentées.

Pour obtenir ces régions 110 et 112, la couche superficielle 106 est par exemple réalisée à partir d'une couche de silicium dans laquelle les premières régions 110 de SiGe contraint en compression sont réalisées par enrichissement en germanium, comme précédemment décrit en lien avec les figures 1 à 3. Au cours de ce procédé d'enrichissement en germanium, un masque recouvre les parties de la couche de silicium destinées à former les deuxièmes régions 112 afin que le silicium de ces parties recouvertes par le masque ne soit pas modifié par l'enrichissement en germanium mis en œuvre pour former le SiGe contraint en compression des premières régions 110.

Le masque utilisé pour recouvrir les régions de la couche de semi-conducteur qui ne seront pas modifiées par l'enrichissement en germanium est par exemple formé d'une première couche de SiO₂ d'épaisseur comprise entre environ 5 nm et 10 nm, et d'une deuxième couche de SiN d'épaisseur comprise entre environ 30 nm et 100 nm.

Après avoir réalisé le masque sur la couche de silicium, les étapes permettant de transformer le silicium des futures premières régions 110 en SiGe contraint en compression sont mises en œuvre. Pour cela, une couche de SiGe est tout d'abord formée par épitaxie sur les parties de la couche de silicium qui ne sont pas recouvertes par le masque. Cette couche de SiGe a par exemple une épaisseur comprise entre environ 5 nm et 30 nm, et le pourcentage de germanium dans le SiGe de cette couche, c'est-à-dire le pourcentage atomique de germanium dans ce SiGe, est par exemple compris entre environ 20 % et 50 %.

Une étape d'oxydation thermique de cette couche de SiGe est ensuite mise en œuvre. Cette oxydation peut comporter par exemple une première étape d'oxydation sèche, par exemple par oxydation thermique rapide (RTO pour « Rapid Thermal Oxidation ») mise en œuvre à une température comprise entre environ 850°C et 950°C, ou entre 900°C et 1100°C pour diffuser les atomes de germanium. Une deuxième étape de recuit sous une atmosphère neutre, par exemple sous une atmosphère de N₂, peut être mise en œuvre, par exemple à une température supérieure à la température de mise en œuvre de la précédente oxydation et comprise entre environ 950°C et 1100°C pour homogénéiser la concentration des atomes de germanium diffusés. Les températures mises en jeu lors de cette oxydation sont telles qu'elles sont inférieures à la température de fusion du semi-conducteur contraint des premières régions 110. Ces deux étapes peuvent être mises en œuvre une seule fois, avec dans ce cas une première étape d'oxydation mise en œuvre pendant une durée suffisante pour obtenir, à l'issue de cette première étape, la concentration en germanium souhaitée dans le semi-conducteur des premières régions 110 de la couche superficielle 106. En variante, ces deux étapes peuvent être mises en œuvre plusieurs fois l'une après l'autre de manière cyclique, avec dans ce cas des durées de mise en œuvre des premières étapes d'oxydation réduites. L'enrichissement en germanium du semi-conducteur des premières régions 110 obtenu peut être tel que le taux de germanium dans le SiGe contraint obtenu soit compris entre environ 20 % et 50 %.

La durée de l'oxydation thermique pendant laquelle le semi-conducteur est exposé à des températures élevées dépend notamment de l'épaisseur de la couche de SiGe formée sur la couche de silicium, ainsi que de la concentration en germanium du SiGe de cette couche.

L'oxydation provoque une migration d'atomes de germanium issus de la couche de SiGe dans le silicium des premières régions 110 de la couche superficielle 106. Cet enrichissement en germanium du silicium modifie la nature de ce semi-conducteur qui devient du SiGe contraint en compression. A l'issue de cette étape, le semi-conducteur des premières régions 110 de la couche superficielle 106, c'est-à-dire le semi-conducteur de la couche superficielle 106 qui n'est pas recouvert par le masque, correspond à du SiGe contraint en compression. Grâce à la présence du masque recouvrant les deuxièmes régions 112 de la couche superficielle 106, la nature du silicium de ces deuxièmes régions 112 n'est pas modifiée par la mise en œuvre de ces étapes. Une couche d'oxyde formée par l'oxydation de la couche de SiGe et comprenant par exemple majoritairement du SiO₂, ainsi que le masque utilisé, sont ensuite retirés.

Selon un autre exemple, lorsque la couche de silicium comporte une épaisseur égale à environ 11 nm, et que la couche de SiGe formée sur la couche de silicium comporte du Si_{0.75}Ge_{0.25} et une épaisseur égale à environ 8,5 nm formée par RT-CVD (« Rapid Thermal Chemical Vapor Déposition » ou dépôt chimique en phase vapeur à chauffage rapide), l'étape d'oxydation thermique de la couche de SiGe peut correspondre à la mise en œuvre d'une oxydation thermique rapide à une température égale à environ 1100°C pendant une durée comprise entre environ 45 secondes et 50 secondes. Il en résulte la formation d'une région 110 de SiGe contraint en compression ayant une épaisseur comprise entre environ 12 nm et 13 nm et dans laquelle la concentration en germanium varie linéairement depuis la surface supérieure (celle en contact avec la couche de SiGe) où le pourcentage atomique du germanium est égal à environ 27 % jusqu'à l'interface avec la couche diélectrique enterrée 104 où ce pourcentage atomique est égal à environ 5 %.

L'isolation des différentes régions de la couche superficielle 106 est ici destinée à être assurée par des tranchées d'isolation, par exemple de type STI.

Pour cela, un masque de gravure 114 est réalisé sur la couche superficielle 106 (figure 6). Les ouvertures formées à travers le masque 114, correspondant au motif du masque de gravure 114, définissent la ou les tranchées d'isolation destinées à être réalisées au moins à travers la couche superficielle 106. Dans l'exemple de réalisation décrit ici, les tranchées d'isolation sont destinées à traverser les couches 106 et 104 et une partie de l'épaisseur de la couche support 102, afin d'isoler électriquement les unes des autres non seulement les différentes régions réalisées dans la couche superficielle 106, mais également les parties de la couche support 102 se trouvant sous ces régions afin de pouvoir réaliser une polarisation de ces parties de la couche support 102 indépendamment les unes des autres. Les couches 106, 104 et 102 sont donc gravées selon le motif du masque 114 (voir la figure 7), formant des tranchées d'isolation 116 traversant complètement les couches 106 et 104 et une partie de l'épaisseur de la couche support 102.

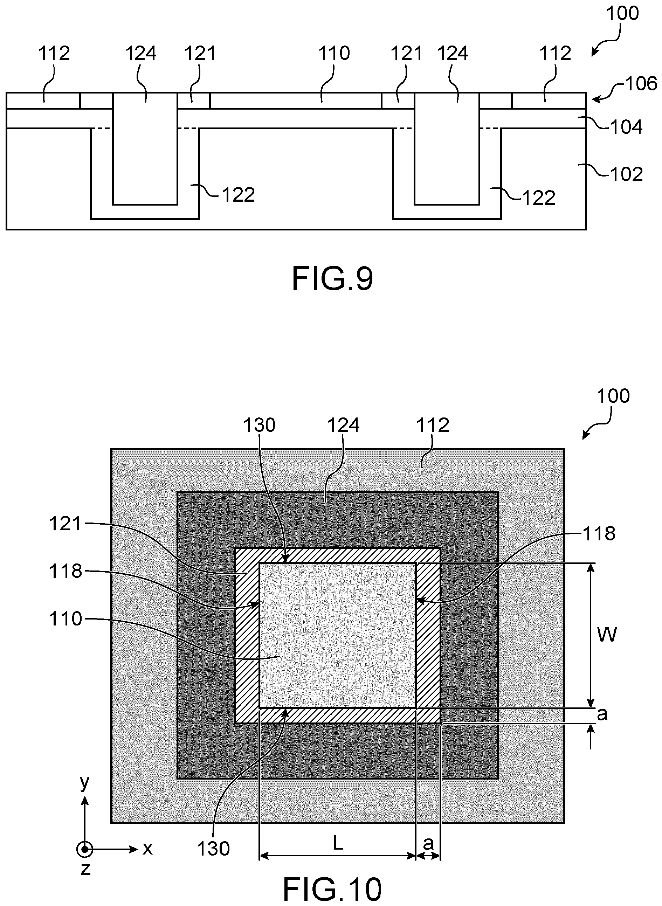

Cette gravure de la couche superficielle 106 révèle des premiers bords latéraux 118 et des deuxièmes bords latéraux 130 de la première région 110 qui est recouverte par le masque 114. Sur les figures 7 et 8, seuls les deux premiers bords latéraux 118 sont visibles, les deux deuxièmes bords latéraux 130 étant visibles sur la figure 10.

Lorsque la contrainte dans le matériau du masque 114 est neutre ou proche d'une contrainte neutre, le masque 114 forme un élément mécanique contribuant à maintenir la contrainte compressive du semi-conducteur de la première région 110, et cela bien que les tranchées d'isolation 116 aient été gravées autour de la première région 110.

Afin d'éviter une relaxation excessive du semi-conducteur contraint de la première région 110 lorsque le masque 114 sera retiré ultérieurement, des premières portions 120 de semi-conducteur contraint faisant partie de la première région 110 et formant les bords latéraux 118 et 130 sont modifiées en des deuxièmes portions 121 de matériau formant, lors du retrait du masque 114, des éléments d'appui mécanique disposés contre la première région 110, évitant au semi-conducteur contraint de se relaxer excessivement lors du retrait du masque 114.

Dans le premier mode de réalisation décrit ici, la modification des premières portions 120 correspond à la mise en œuvre d'une réaction chimique transformant le semi-conducteur contraint des premières portions 120 en un autre matériau formant les deuxièmes portions 121.

Selon un premier exemple de réalisation, cette réaction chimique correspond à une oxydation du semi-conducteur contraint. Cette oxydation correspond par exemple à une oxydation thermique, par exemple de type RTO, ou une oxydation assistée par plasma, ou plus généralement toute oxydation sèche ou humide adaptée pour transformer le semi-conducteur contraint des premières portions 120.

Selon un deuxième exemple de réalisation, cette réaction chimique correspond à une nitruration, par exemple assistée par plasma. A titre d'exemple, cette nitruration peut être mise en œuvre en faisant appel à des faisceaux d'électrons, ou bien être de type PECVD (« Plasma-Enhanced Chemical Vapor Déposition » en anglais, ou dépôt chimique en phase vapeur assisté par plasma), ECR (« Electron Cyclotron Resonance » en anglais, ou résonance cyclotron électronique), par faisceau d'ions, par implantation d'atomes d'azote à faible énergie, ou encore en utilisant un plasma d'azote couplé de manière inductive, etc.

Ainsi, les premières portions 120 de semi-conducteur contraint, ici du SiGe contraint, sont transformées en des deuxièmes portions 121 de matériau qui est, dans ce premier mode de réalisation, différent du semi-conducteur contraint (voir figure 8). Selon les exemples de réalisation décrits ci-dessus, le matériau des deuxièmes portions 121 est par exemple de l'oxyde de semi-conducteur et/ou du nitrure de semi-conducteur.

En transformant le matériau des première portions 120 sans modifier celui du reste de la région 110, l'interface entre le semi-conducteur contraint de la région 110 et le matériau diélectrique de la couche diélectrique enterrée 104 est modifiée au niveau des premier et deuxièmes bords latéraux 118, 130. Les deuxièmes portions 121 forment alors des barrières mécaniques, ou éléments d'appui mécanique, qui empêchent, lors du retrait du masque 114, une relaxation excessive du semi-conducteur contraint de la région 110 qui se produit notamment à l'interface avec la couche diélectrique enterrée 104.

Cette modification est réalisée telle que la largeur des premières portions 120, selon une direction sensiblement perpendiculaire aux bords latéraux 118, 130 (correspondant à la dimension « a » sur la figure 8) est comprise entre environ 3 nm et 25 nm, ou entre 5 nm et 20 nm. Dans l'exemple de réalisation décrit ici, le semi-conducteur de la couche 102 est également exposé à la réaction chimique mise en œuvre pour transformer le semi-conducteur contraint des premières portions 120. Ainsi, le semi-conducteur de la couche 102 qui est exposé dans les tranchées 116 lors de la mise en œuvre de la réaction chimique est également transformé en oxyde de semi-conducteur (par exemple en SiO₂) et/ou en nitrure de semi-conducteur (par exemple en Si₃N₄). Une couche de SiO₂ 122 est donc formée dans les tranchées 116 au niveau des parois latérales et de la paroi de fond des tranchées 116.

Les tranchées 116 sont ensuite remplies par un ou plusieurs matériaux diélectriques, par exemple du SiO₂, afin de former des tranchées d'isolation 124. Le dépôt du ou des matériaux diélectriques peut être suivi d'un recuit de densification. Le masque 114 est ensuite retiré sans que le semi-conducteur contraint de la première région 110 ne se relaxe excessivement, achevant la réalisation du substrat 100 (voir la figure 9).

Il est possible, suivant la technique de dépôt utilisé, que le masque soit également recouvert du matériau diélectrique déposé pour former les tranchées d'isolation 124. Dans ce cas, le matériau présent sur le masque peut être supprimé, par exemple par planarisation mécano-chimique, ou CMP.

La figure 10 représente une vue de dessus de la partie de la couche superficielle 106 comprenant la première région 110 dans laquelle des transistors de type P sont destinés à être réalisés. Dans le plan principal de la couche superficielle 106 (plan sensiblement parallèle à l'interface entre la couche superficielle 106 et la couche diélectrique enterrée 104, ou plan parallèle aux faces de plus grandes dimensions de la couche superficielle 106, qui est parallèle au plan (X,Y)), la première région 110 a par exemple une forme sensiblement rectangulaire, comme c'est le cas sur la figure 10. Cette première région 110 de la couche superficielle 106, comprenant le SiGe contraint en compression, est entourée par les deuxièmes portions 121 qui comprennent, dans les exemples de réalisation décrits, de l'oxyde formé par une oxydation du SiGe des premières portions 120 et/ou du nitrure formé par la nitruration du SiGe des premières portions 120 et qui forment les bords latéraux 118, 130. Les tranchées d'isolation 124 entourent ces portions 121. La dimension nommée « L » correspond à la longueur de la première région 110, et est parallèle à la longueur de canaux des transistors qui seront réalisés dans cette première région 110 (la longueur des canaux correspondant à la dimension des canaux parallèles à la direction de transport des charges dans les canaux). La dimension nommée « W » correspond à la largeur de la première région 110, et est parallèle à la largeur des canaux des transistors.

En variante, la première région 110 peut avoir, dans le plan principal de la couche 106, une forme composée de plusieurs rectangles juxtaposés dont les bords ne sont pas alignés et/ou sont de dimensions différentes, ou bien une toute autre forme.

Avec les portions 121 présentes contre tous les bords de la première région 110 de la couche superficielle 106, la contrainte en compression est conservée dans le semi-conducteur de la première région 110 de la couche superficielle 106 et une relaxation excessive de cette contrainte est évitée notamment selon deux directions sensiblement perpendiculaires l'une de l'autre, l'une de ces deux directions correspondant à la direction de circulation du courant dans les canaux des transistors qui seront réalisés dans la première région 110 (ces deux directions correspondent à celles parallèles aux axes X et Y visibles sur la figure 10).

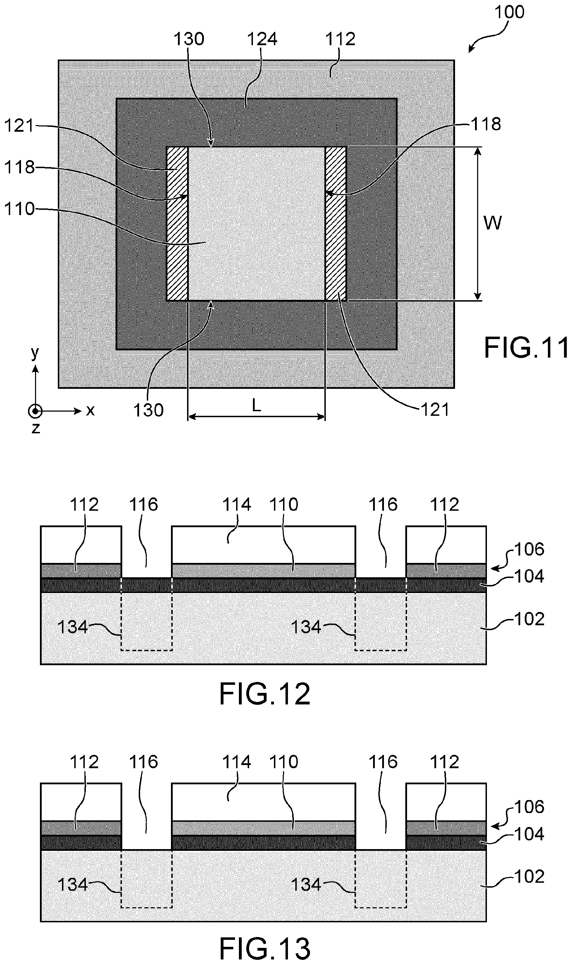

Selon une variante, il est possible que les portions 121 ne soient pas présentes contre tous les bords de la première région 110. La figure 11 représente une telle variante de réalisation. Sur cette figure, les portions 121 sont localisées contre les deux premiers bords 118 opposés de la première région 110 de la couche superficielle 106. Les deux portions 121 sont chacune orientées, c'est-à-dire comprennent leur plus grande dimension, sensiblement perpendiculairement à la longueur des canaux des transistors destinés à être réalisés dans la première région 110. Aucune portion 121 n'est présente contre les deuxièmes bords 130 de la région 110 qui sont sensiblement parallèles à la longueur L. Selon cette variante, une relaxation excessive de la contrainte compressive est empêchée selon l'axe parallèle à la longueur L grâce à la présence des portions 121 contre les premiers bords 118 de la région 110. Une relaxation de la contrainte peut par contre se produire selon l'axe parallèle à la largeur W de la région 110 en raison de l'absence de portions 121 contre les deuxièmes bords 130. Ainsi, des conditions favorables au maintien de la contrainte compressive selon la longueur L et des conditions favorables à la relaxation de la contrainte compression selon la largeur W sont obtenues. Cette configuration favorise l'obtention d'une contrainte compressive à caractère uniaxial augmenté selon l'axe parallèle à la longueur L.

Dans le premier mode de réalisation décrit ci-dessus, les portions 121 sont formées au niveau de bords latéraux révélés lors de la réalisation des tranchées d'isolation 124. En variante, il est possible de former les portions 121 au niveau de zones gravées qui ne correspondent pas aux tranchées d'isolation 124. Dans ce cas, les tranchées 116 peuvent être réalisées uniquement à travers la couche superficielle 106 et non à travers la couche diélectrique 104 et la couche support 102.

Dans le premier mode de réalisation décrit ci-dessus, le semi-conducteur de la couche support 102 faisant partie des parois latérales des tranchées 116 subit la réaction chimique mise en œuvre pour former les deuxièmes portions 121. Afin de minimiser l'impact de cette oxydation sur le semi-conducteur de la couche support 102, il est possible que cette oxydation soit mise en œuvre de manière sélective, c'est-à-dire telle que l'oxydation du SiGe des premières portions 120 soit plus rapide que celle du silicium de la couche support 102. Une telle oxydation sélective correspond par exemple à une oxydation humide telle que décrite dans le document « Wet oxidation of GeSistrained layers by rapid thermal processing » de D.K. Nayak et al., Appl. Phys. Lett. 57, 369 (1990).

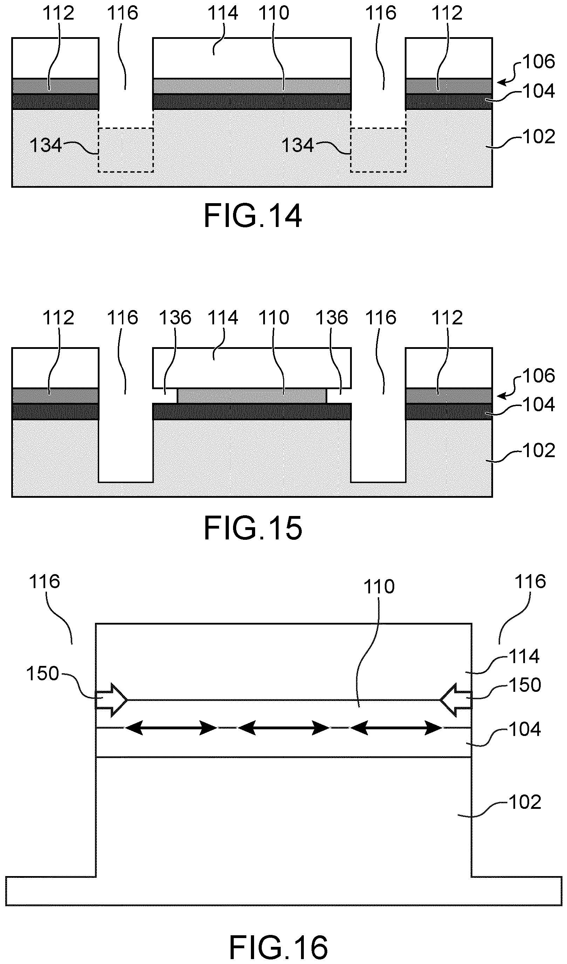

Il est également possible, pour minimiser l'impact de la réaction chimique réalisée pour former les portions 121, de réaliser les tranchées 116 en plusieurs étapes. Par exemple, à partir l'étape précédemment décrite en lien avec la figure 6, il est possible de réaliser les tranchées 116 seulement à travers la couche superficielle 106 (comme représenté sur la figure 12) ou à travers la couche superficielle 106 et au moins une partie de l'épaisseur de la couche diélectrique enterrée 104 (comme représenté sur la figure 13), ou à travers les couches 104 et 106 et une partie de l'épaisseur de la couche 102, tout en étant inférieure à l'épaisseur finale souhaitée pour les tranchées d'isolation 124 (comme représenté sur la figure 14). Sur les figures 12 à 14, la profondeur finale souhaitée pour les tranchées d'isolation 124 est représentée en pointillés et référencée 134. La ou les étapes de modification du semi-conducteur contraint des premières portions 120 sont ensuite mises en œuvre, puis la gravure des tranchées 116 est achevée jusqu'à atteindre la profondeur souhaitée pour les tranchées d'isolation 124. Il convient de noter que cette dernière étape de gravure supprime l'oxyde et/ou le nitrure de semi-conducteur formé au niveau de la paroi de fond des tranchées 116 lorsque la transformation du semi-conducteur des premières portions 120 comporte la mise en œuvre d'une oxydation et/ou d'une nitruration de ce semi-conducteur (dans le cas de la figure 14, l'oxyde et/ou le nitrure de semi-conducteur formé au niveau de la paroi de fond des tranchées 116 peut être conservé). Le matériau diélectrique des tranchées 124 est ensuite déposé dans les tranchées 116.

Dans le premier mode de réalisation précédemment décrit, les deuxièmes portions 121 sont obtenues par réaction chimique transformant le matériau des premières portions 120. En variante, préalablement à la mise en œuvre de cette réaction chimique, il est possible de réaliser un retrait, ou une gravure, d'une partie du semi-conducteur contraint de ces premières portions 120, par exemple sur une largeur (parallèle à la dimension « a » précédemment décrite) par exemple comprise entre environ 5 nm et 10 nm, puis de mettre en œuvre la réaction chimique comme précédemment décrit à partir du semi-conducteur restant des premières portions 120.

Selon un deuxième mode de réalisation, la modification des premières portions 120 peut correspondre à un remplacement du semi-conducteur contraint de ces premières portions 120 par un autre matériau formant les deuxièmes portions 121. Pour cela, après avoir gravé la couche superficielle 106, une gravure des premières portions 120 est mise en œuvre, formant ainsi des cavités 136 entre le masque 114 et la couche diélectrique enterrée 104 (voir la figure 15). Un autre matériau, différent ou non du semi-conducteur contraint, est ensuite déposé dans les cavités 136 pour former les deuxièmes portions 121.

Dans ce deuxième mode de réalisation, les deuxièmes portions 121 peuvent être réalisées en même temps que les tranchées d'isolation 124. Dans ce cas, le ou les matériaux des deuxièmes portions 121 sont diélectriques et similaires à celui ou ceux des tranchées d'isolation 124. De manière avantageuse, dans ce deuxième mode de réalisation, une première oxydation peut être mise en œuvre (par exemple une oxydation thermique rapide) pour obtenir une couche d'oxyde d'épaisseur comprise entre 1 nm et 10 nm. Cette oxydation peut être suivie par un dépôt de nitrure, par exemple de type SACVD (dépôt chimique en phase vapeur à pression sub-atmosphérique), PECVD, ou encore ALD (dépôt de couche atomique), par exemple du SiBCN et/ou du SiN, d'épaisseur comprise entre environ 2 et 15 nm, et/ou un dépôt d'oxyde par exemple du SiO₂, déposé par exemple par HDPCVD ou tout autre dépôt adapté.

En variante, il est possible que le matériau déposé dans les cavités 136 corresponde à un semi-conducteur, comme par exemple du silicium et/ou du Ge et/ou du SiGe. Du fait que ce semi-conducteur n'a pas été soumis au procédé de condensation de la première région 110, ce semi-conducteur forme bien un élément d'appui mécanique permettant d'empêcher la relaxation du SiGe contraint lors du retrait du masque 114.

Ce semi-conducteur des deuxièmes portions 121 peut être déposé sous une forme amorphe, puis un recuit de recristallisation peut être mis en œuvre. La recristallisation peut également intervenir au cours d'un recuit ultérieur mis en œuvre par exemple au cours de la réalisation des transistors dans le substrat 100. En variante, le semi-conducteur peut être déposé sous forme cristalline, par exemple par croissance. Une épitaxie sélective peut par exemple être mise en œuvre.

De plus, il est également envisageable de réaliser une réaction chimique du semi-conducteur déposé, par exemple une oxydation et/ou une nitruration.

De manière générale, différents matériaux diélectriques et/ou semi-conducteurs peuvent être combinés pour former les deuxièmes portions 121.

De manière avantageuse, lorsque le matériau déposé et formant les deuxièmes portions 121 est un semi-conducteur, les tranchées 116 sont gravées telles qu'elles traversent la couche diélectrique 104, voire une partie de la couche support 102. Ainsi, après le dépôt du semi-conducteur dans les cavités, le semi-conducteur se trouvant dans les tranchées 116 est éliminé par la gravure mise en œuvre pour achever la gravure des tranchées 116, éliminant toute liaison entre le semi-conducteur déposé dans les cavités et le semi-conducteur de la couche support 102.

Les variantes précédemment décrites en lien avec le premier mode de réalisation, notamment la réalisation des tranchées 116 en plusieurs étapes comme précédemment décrit en lien avec les figures 12 à 14, peuvent s'appliquer à ce deuxième mode de réalisation. Dans ce cas, le matériau qui se retrouve déposé dans les tranchées 116 et non dans les cavités 136 est supprimé par la gravure mise en œuvre pour achever la réalisation des tranchées 116.

Dans les modes de réalisation et les variantes précédemment décrits, les deuxièmes régions 112 adjacentes à la première région 110 ne comportent pas le semi-conducteur contraint présent dans la première région 110. En variante, il est possible que ces deuxièmes régions 112 comportent le même semi-conducteur contraint que celui de la première région 110. Dans ce cas, des portions 121 formant des appuis mécaniques peuvent être réalisées au niveau des bords latéraux de ces deuxièmes régions 112, en regard des deuxièmes portions 121 formant les éléments d'appui mécanique pour la première région 110.

Dans les modes de réalisation précédemment décrits, le semi-conducteur contraint en compression correspond à du SiGe. Le procédé décrit précédemment peut toutefois s'appliquer pour d'autres semi-conducteurs et/ou une contrainte différente.

Dans les modes de réalisation et variantes décrits ci-dessus, le semi-conducteur de la première région 110 correspond à un semi-conducteur contraint en compression. Cette contrainte peut être modulée ou modifiée en réalisant le masque 114 tel que celui-ci soit également réalisé avec un matériau contraint. Ainsi, en réalisant le masque 114 avec un matériau contraint en tension, la contrainte en compression du semi-conducteur de la région 110 peut être renforcée.

En variante, en réalisant le masque 114 avec un matériau contraint en compression, la contrainte en compression initiale du semi-conducteur de la région 110 peut être modifiée au point de devenir nulle, voire devenir une contrainte en tension. Un tel masque 114 peut comporter du SiN, avec différentes natures de contrainte (en compression ou en tension) et différents niveaux de contrainte possibles. Ce masque 114 peut être réalisé selon par exemple des méthodes décrites dans le document « A comparison of the mechanical stability of silicon nitride films deposited » de P. Morin et al., Applied Surface Science, vol.260, 1 novembre 2012, pages 69-72.

La figure 16 représente un premier exemple de réalisation de cette variante dans lequel le masque 114 comporte un matériau contraint en tension. Le masque 114 apporte une contrainte en compression supplémentaire au matériau de la première région 110 qui correspond à du SiGe initialement contraint en compression. Cette contrainte en compression supplémentaire est représentée symboliquement sur la figure 16 par des flèches référencées 150. Un tel matériau de la première région 110 fortement contraint en compression peut par exemple servir à la réalisation de transistors PMOS.

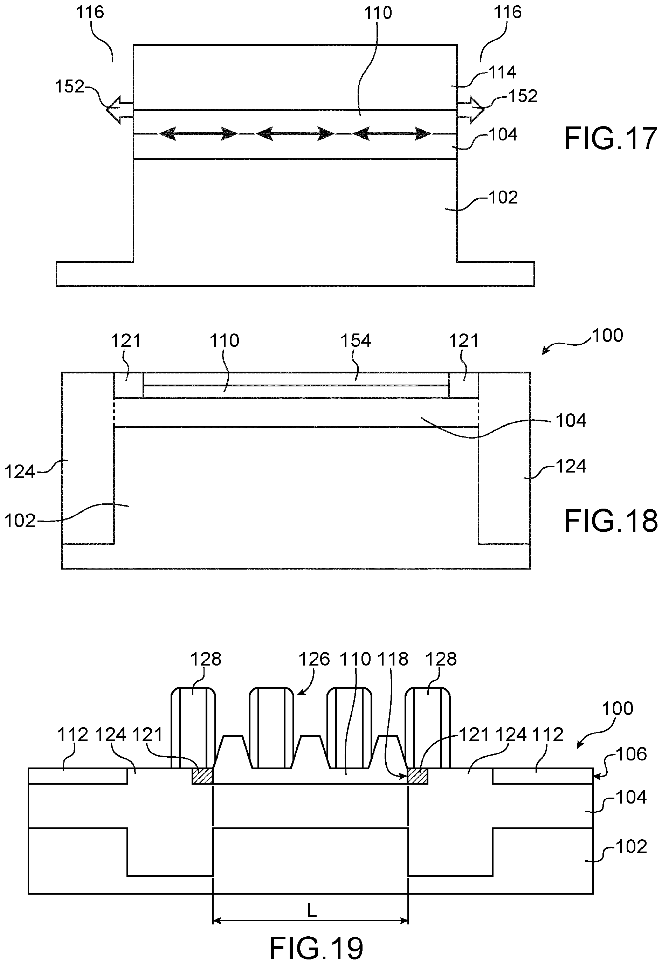

La figure 17 représente un deuxième exemple de réalisation de cette variante dans lequel le masque 114 comporte un matériau contraint en compression. Le masque 114 apporte une contrainte en tension au matériau de la première région 110 qui correspond à du SiGe initialement contraint en compression. La contrainte en tension apportée par le masque 114 est représentée par des flèches référencées 152. L'apport de cette contrainte en tension peut permettre à obtenir, dans le matériau de la première région 110, une contrainte sensiblement nulle voire une contrainte en tension.

Il est par exemple possible de réaliser, dans un substrat comprenant les couches 102, 104 et 106 et dans lequel la couche 106 comporte du SiGe contraint en compression obtenu par condensation de Ge, des régions de la couche 106 sur lesquelles le masque 114 comporte une contrainte neutre ou en tension et dans lesquelles une contrainte en compression est conservée ou augmentée dans ces régions de SiGe de la couche 106, servant par exemple pour la réalisation de transistors PMOS, et d'autres régions de la couche 106 sur lesquelles le masque 114 comporte une contrainte en compression et dans lesquelles une contrainte neutre ou en tension est obtenue dans ces régions de SiGe de la couche 106 servant par exemple pour la réalisation de transistors NMOS.

A partir du SiGe non contraint ou contraint en tension de la première région 110 décrite ci-dessus, il est possible de réaliser un amincissement de ce SiGe, puis de mettre en œuvre une épitaxie pour faire croître du silicium 154 sur l'épaisseur restante de SiGe. Le substrat 100 obtenu est représenté sur la figure 18.

Les variantes décrites ci-dessus peuvent s'appliquer aux deux modes de réalisation précédemment décrits.

Les étapes ci-dessous correspondent aux étapes mises en œuvre pour réaliser le substrat 100 selon la configuration représentée sur la figure 11, selon un premier exemple de réalisation :
- lithographie et gravure des premières tranchées 116 orientées parallèlement à l'axe X ;
- dépôt du matériau diélectrique d'isolation dans ces premières tranchées 116, avec une planarisation mécano-chimique pour supprimer le matériau diélectrique se trouvant en dehors des premières tranchées 116 ;
- lithographie et gravure des deuxièmes tranchées 116 orientées parallèlement à l'axe Y ;
- réalisation des portions 121 via une modification des premières portions 120 formant les premiers bords latéraux 118 dans ces deuxièmes tranchées 116 ;
- dépôt du matériau diélectrique d'isolation dans les deuxièmes tranchées 116, avec une planarisation mécano-chimique pour supprimer le matériau diélectrique se trouvant en dehors des deuxièmes tranchées 116.

Les étapes ci-dessous correspondent aux étapes mises en œuvre pour réaliser le substrat 100 selon la configuration représentée sur la figure 11, selon un deuxième exemple de réalisation :
- lithographie et gravure des deuxièmes tranchées 116 orientées parallèlement à l'axe Y ;
- réalisation des portions 121 via une modification des premières portions 120 formant les premiers bords latéraux 118 dans ces deuxièmes tranchées 116 ;
- dépôt du matériau diélectrique d'isolation dans les deuxièmes tranchées 116, avec une planarisation mécano-chimique pour supprimer le matériau diélectrique se trouvant en dehors des deuxièmes tranchées 116 ;
- lithographie et gravure des premières tranchées 116 orientées parallèlement à l'axe X ;
- dépôt du matériau diélectrique d'isolation dans ces premières tranchées 116, avec une planarisation mécano-chimique pour supprimer le matériau diélectrique se trouvant en dehors des premières tranchées 116.

Les étapes ci-dessous correspondent aux étapes mises en œuvre pour réaliser le substrat 100 selon la configuration représentée sur la figure 11, selon un troisième exemple de réalisation :
- lithographie et gravure des deuxièmes tranchées 116 orientées parallèlement à l'axe Y ;
- réalisation des portions 121 via une modification des premières portions 120 formant les premiers bords latéraux 118 dans ces deuxièmes tranchées 116 ;
- lithographie et gravure des premières tranchées 116 orientées parallèlement à l'axe X ;
- dépôt du matériau diélectrique d'isolation dans les premières et deuxièmes tranchées 116, avec une planarisation mécano-chimique pour supprimer le matériau diélectrique se trouvant en dehors des tranchées 116.

A partir du substrat 100 obtenu, des transistors sont réalisés en mettant en œuvre les différentes étapes formant ces transistors (lithographie, gravure, réalisation des grilles, épitaxie, dopage, etc.). Des transistors FET de type P 126 sont réalisés dans la première région 110 de SiGe contraint en compression (voir la figure 19). De manière avantageuse, ces transistors FET réalisés sont de type FDSOI, FinFet, à nanofils ou à nanofeuilles.

Ces transistors 126 sont avantageusement réalisés avec des régions de source et de drain comprenant du SiGe avec une concentration en germanium supérieure à celle dans le SiGe contraint de la première région 110. Ainsi, la différence de paramètre de maille entre le semi-conducteur (du SiGe dans le mode de réalisation décrit ici) de ces régions de source et de drain et le semi-conducteur (également du SiGe dans le mode de réalisation décrit ici) contraint de la première région 110 tend à générer, ou augmenter comme c'est le cas ici, une contrainte en compression dans les canaux des transistors 126. Dans le mode de réalisation décrit ici, un transfert important de la contrainte en compression depuis les régions de source et de drain vers les canaux des transistors 126 est obtenu grâce aux portions 121 confinant le SiGe contraint de la région 110.

Dans une configuration usuelle, la grille des transistors se trouvant au plus près de la tranchée d'isolation 124 sont des grilles factices ne remplissant aucune fonction électronique. Deux grilles factices 128 sont représentées sur la figure 16. La grille est disposée partiellement sur les tranchées d'isolation 124. En outre, les portions 121 se trouvent également sous ces grilles factices 128.

Dans un mode préférentiel, la largeur des portions 121, c'est-à-dire la dimension appartenant au plan principal de la couche superficielle 106 et qui, de chaque côté de la région 110 de la couche superficielle 106, est sensiblement perpendiculaire aux parois latérales de la tranchée d'isolation 124, est telle que les portions 121 ne font pas partie des canaux des transistors FET de type P 126 qui ne sont pas factices. Pour cela, la largeur des portions 121 est par exemple inférieure ou égale à 0,5 CPP (« Contacted Poly Pitch », qui correspond à la distance inter-grille, c'est-à-dire le pas entre les grilles de deux transistors voisins). Ainsi, dans la configuration représentée en figure 19, les portions 121 ne sont pas disposées sous la grille d'un transistor électriquement actif, c'est-à-dire dans la région de canal d'un tel transistor (les portions 121 peuvent par contre être disposées dans une région de source ou de drain d'un tel transistor).

Ce procédé peut être mis en oeuvre tel que les régions de semi-conducteur obtenues pour réaliser des transistors de type PMOS comporte du SiGe contraint en compression ou du SiGe non contraint ou du silicium non contraint, et/ou que les régions de semi-conducteur obtenues pour réaliser des transistors de type NMOS comporte du SiGe contraint en tension ou du SiGe non contraint ou du silicium non contraint.

## Revendications

1. Procédé de réalisation d'un substrat semi-conducteur (100), comprenant au moins la mise en œuvre des étapes suivantes :
- réalisation d'une couche superficielle (106) disposée sur une couche diélectrique enterrée (104) et comprenant au moins une région (110) de semi-conducteur contraint ;
- réalisation d'un masque de gravure (114) sur la couche superficielle (106), recouvrant au moins une partie de la région (110) de semi-conducteur contraint ;
- gravure de la couche superficielle (106) selon un motif du masque de gravure (114), révélant au moins un premier bord latéral (118) formé par au moins une première portion (120) de semi-conducteur contraint appartenant à ladite partie de la région (110) de semi-conducteur contraint et qui est en contact avec la couche diélectrique enterrée (104) ;
- modification de la première portion (120) de semi-conducteur contraint en au moins une deuxième portion (121) de matériau formant un élément d'appui mécanique disposé contre la région (110) de semi-conducteur contraint ;
- retrait du masque de gravure (114).

2. Procédé selon la revendication 1, dans lequel l'étape de modification de la première portion (120) de semi-conducteur contraint comporte la mise en œuvre d'une réaction chimique transformant le semi-conducteur contraint.

3. Procédé selon la revendication 2, dans lequel la réaction chimique correspond à une oxydation et/ou une nitruration du semi-conducteur contraint.

4. Procédé selon l'une des revendications 2 et 3, dans lequel l'étape de modification de la première portion (120) de semi-conducteur contraint comporte en outre, préalablement à la mise en œuvre de la réaction chimique du semi-conducteur contraint, une étape de retrait d'une partie de la première portion (120) de semi-conducteur contraint, et dans lequel la réaction chimique est ensuite mise en œuvre à partir du reste de la première portion (120) de semi-conducteur contraint.

5. Procédé selon la revendication 1, dans lequel l'étape de modification de la première portion (120) de semi-conducteur contraint comporte :
- une gravure de la première portion (120) de semi-conducteur contraint, formant au moins une cavité (136) disposée entre la couche diélectrique enterrée (104) et le masque de gravure (114), puis
- une étape de réalisation, dans la cavité (136), de la deuxième portion (121) de matériau.

6. Procédé selon l'une des revendications précédentes, dans lequel le matériau de la deuxième portion correspond à au moins un matériau semi-conducteur et/ou un matériau diélectrique.

7. Procédé selon l'une des revendications précédentes, dans lequel le semi-conducteur contraint correspond à du SiGe contraint en compression, et dans lequel la couche superficielle (106) est réalisée par enrichissement de germanium dans une couche de silicium.

8. Procédé selon l'une des revendications précédentes, dans lequel le motif du masque de gravure (114) définit des tranchées d'isolation (116) disposées autour de la région (110) de semi-conducteur contraint, et dans lequel le procédé comporte en outre, après l'étape de modification de la première portion (120) de semi-conducteur contraint, une étape de dépôt d'au moins un matériau diélectrique (124) dans les tranchées d'isolation (116).

9. Procédé selon la revendication 8, comportant en outre, entre l'étape de modification de la première portion (120) de semi-conducteur contraint et l'étape de retrait du masque dur (114), la mise en œuvre d'une étape de gravure prolongeant les tranchées d'isolation (116) à travers au moins une partie de l'épaisseur de la couche diélectrique enterrée (104), ou à travers la couche diélectrique enterrée (104) et une partie de l'épaisseur d'une couche support (102) disposée telle que la couche diélectrique enterrée (104) soit disposée entre la couche support (102) et la couche superficielle (106).

10. Procédé selon l'une des revendications précédentes, dans lequel une dimension de la première portion (120) de semi-conducteur contraint, selon une direction sensiblement perpendiculaire au premier bord latéral (118), est comprise entre environ 3 nm et 25 nm.

11. Procédé selon l'une des revendications précédentes, dans lequel l'étape de gravure de la couche superficielle (106) grave le motif du masque de gravure (114) à travers la couche superficielle (106), ou à travers la couche superficielle (106) et au moins une partie de l'épaisseur de la couche diélectrique enterrée (104), ou à travers la couche superficielle (106), la couche diélectrique enterrée (104) et une partie de l'épaisseur d'une couche support (102) disposée telle que la couche diélectrique enterrée (104) soit disposée entre la couche support (102) et la couche superficielle (106).

12. Procédé selon l'une des revendications précédentes, dans lequel :
- la région (110) de semi-conducteur contraint a, dans un plan principal de la couche superficielle (106), une forme sensiblement rectangulaire ;
- le motif du masque de gravure (114) est tel que la gravure de la couche superficielle (106) révèle au moins deux premiers bords latéraux (118) opposés et formés par la partie de la région (110) de semi-conducteur contraint ;
- l'étape de modification est mise en œuvre telle qu'elle modifie au moins deux premières portions (120) de semi-conducteur contraint qui forment les deux premiers bords latéraux (118) et qui sont en contact avec la couche diélectrique enterrée (104).

13. Procédé selon la revendication 12, dans lequel :
- le motif du masque de gravure (114) est tel que la gravure de la couche superficielle (106) révèle en outre au moins deux deuxièmes bords latéraux (130) opposés, formés par la partie de la région (110) de semi-conducteur contraint et sensiblement perpendiculaires aux deux premiers bords latéraux (118) ;
- l'étape de modification est mise en œuvre telle qu'elle modifie au moins quatre premières portions (120) de semi-conducteur contraint qui forment les deux premiers bords latéraux (118) et les deux deuxièmes bords latéraux (130) et qui sont en contact avec la couche diélectrique enterrée (104).

14. Procédé selon l'une des revendications précédentes, dans lequel le masque de gravure (114) comporte au moins un matériau contraint en tension ou en compression.

15. Procédé selon l'une des revendications précédentes, comportant en outre, après le retrait du masque de gravure (114), la mise en œuvre des étapes suivantes :
- amincissement de la région (110) de semi-conducteur contraint ;
- épitaxie d'au moins un deuxième semi-conducteur (154) sur la région (110) de semi-conducteur contraint amincie.

16. Procédé de réalisation d'au moins un transistor FET (126), dans lequel ledit au moins un transistor FET (126) est réalisé dans la région (110) de semi-conducteur contraint d'un substrat semi-conducteur (100) obtenu par la mise en œuvre du procédé selon l'une des revendications précédentes.

## Patentansprüche

1. Verfahren zur Realisierung eines Halbleitersubstrats (100), umfassend wenigstens die Durchführung der folgenden Schritte:
- Realisieren einer Oberflächenschicht (106), die auf einer vergrabenen dielektrischen Schicht (104) angeordnet ist und wenigstens eine Region (110) aus verspanntem Halbleiter umfasst;
- Realisieren einer Ätzmaske (114) auf der Oberflächenschicht (106), die wenigstens einen Teil der Region (110) aus verspanntem Halbleiter bedeckt;
- Ätzen der Oberflächenschicht (106) gemäß einem Motiv der Ätzmaske (114), wodurch wenigstens ein erster lateraler Rand (118) freigelegt wird, der durch wenigstens einen ersten Bereich (120) aus verspanntem Halbleiter gebildet ist, der zu dem Teil der Region (110) aus verspanntem Halbleiter gehört und der in Kontakt mit der vergrabenen dielektrischen Schicht (104) ist;
- Modifizieren des ersten Bereichs (120) aus verspanntem Halbleiter zu wenigstens einem zweiten Bereich (121) aus Material, das ein mechanisches Anlageelement bildet, das gegen die Region (110) aus verspanntem Halbleiter angeordnet ist;
- Entfernen der Ätzmaske (114).

2. Verfahren nach Anspruch 1, bei dem der Schritt des Modifizierens des ersten Bereichs (120) aus verspanntem Halbleiter die Durchführung einer chemischen Reaktion umfasst, die den verspannten Halbleiter transformiert.

3. Verfahren nach Anspruch 2, bei dem die chemische Reaktion einer Oxidation und/oder eine Nitrierung des verspannten Halbleiters entspricht.

4. Verfahren nach einem der Ansprüche 2 und 3, bei dem der Schritt des Modifizierens des ersten Bereichs (120) aus verspanntem Halbleiter ferner vor der Durchführung der chemischen Reaktion des verspannten Halbleiters einen Schritt des Entfernens eines Teils des ersten Bereichs (120) aus verspanntem Halbleiter umfasst, und bei dem die chemische Reaktion anschließend ausgehend vom Rest des ersten Bereichs (120) aus verspanntem Halbleiter durchgeführt wird.

5. Verfahren nach Anspruch 1, bei dem der Schritt des Modifizierens des ersten Bereichs (120) aus verspanntem Halbleiter umfasst:
- ein Ätzen des ersten Bereichs (120) aus verspanntem Halbleiter, wodurch wenigstens ein Hohlraum (136) gebildet wird, der zwischen der vergrabenen dielektrischen Schicht (104) und der Ätzmaske (114) angeordnet ist, und dann
- einen Schritt des Realisierens des zweiten Bereichs (121) aus Material in dem Hohlraum (136).

6. Verfahren nach einem der vorhergehenden Ansprüche, bei dem das Material des zweiten Bereichs wenigstens einem Halbleitermaterial und/oder einem dielektrischen Material entspricht.

7. Verfahren nach einem der vorhergehenden Ansprüche, bei dem der verspannte Halbleiter kompressionsverspanntem SiGe entspricht, und bei dem die Oberflächenschicht (106) durch Anreichern von Germanium in einer Siliziumschicht realisiert wird.

8. Verfahren nach einem der vorhergehenden Ansprüche, bei dem das Motiv der Ätzmaske (114) Isoliergräben (116) definiert, die um die Region (110) aus verspanntem Halbleiter herum angeordnet sind, und bei dem das Verfahren ferner nach dem Schritt des Modifizierens des ersten Bereichs (120) aus verspanntem Halbleiter einen Schritt des Aufbringens wenigstens eines dielektrischen Materials (124) in den Isoliergräben (116) umfasst.

9. Verfahren nach Anspruch 8, ferner umfassend zwischen dem Schritt des Modifizierens des ersten Bereichs (120) aus verspanntem Halbleiter und dem Schritt des Entfernens der Hartmaske (114) die Durchführung eines Ätzschritts, der die Isoliergräben (116) durch wenigstens einen Teil der Dicke der vergrabenen dielektrischen Schicht (104) hindurch verlängert, oder durch die vergrabene dielektrische Schicht (104) und einen Teil der Dicke einer Trägerschicht (102) hindurch, die derart angeordnet ist, dass die vergrabene dielektrische Schicht (104) zwischen der Trägerschicht (102) und der Oberflächenschicht (106) angeordnet ist.

10. Verfahren nach einem der vorhergehenden Ansprüche, bei dem eine Abmessung des ersten Bereichs (120) aus verspanntem Halbleiter entlang einer Richtung im Wesentlichen orthogonal zum ersten lateralen Rand (118) zwischen ungefähr 3 nm und 25 nm enthalten ist.

11. Verfahren nach einem der vorhergehenden Ansprüche, bei dem der Schritt des Ätzens der Oberflächenschicht (106) das Motiv der Ätzmaske (114) durch die Oberflächenschicht (106) hindurch ätzt, oder durch die Oberflächenschicht (106) und wenigstens einen Teil der Dicke der vergrabenen dielektrischen Schicht (104) hindurch, oder durch die Oberflächenschicht (106), die vergrabene dielektrische Schicht (104) und einen Teil der Dicke einer Trägerschicht (102) hindurch, die derart angeordnet ist, dass die vergrabene dielektrische Schicht (104) zwischen der Trägerschicht (102) und der Oberflächenschicht (106) angeordnet ist.

12. Verfahren nach einem der vorhergehenden Ansprüche, bei dem:
- die Region (110) aus verspanntem Halbleiter in einer Hauptebene der Oberflächenschicht (106) eine im Wesentlichen rechteckige Form hat;
- das Motiv der Ätzmaske (114) derart ist, dass das Ätzen der Oberflächenschicht (106) wenigstens zwei erste laterale Ränder (118) freilegt, die entgegengesetzt und durch den Teil der Region (110) aus verspanntem Halbleiter gebildet sind;
- der Schritt des Modifizierens derart durchgeführt wird, dass er wenigstens zwei erste Bereiche (120) aus verspanntem Halbleiter modifiziert, die die zwei ersten lateralen Ränder (118) bilden und die in Kontakt mit der vergrabenen dielektrischen Schicht (104) sind.

13. Verfahren nach Anspruch 12, bei dem:
- das Motiv der Ätzmaske (114) derart ist, dass das Ätzen der Oberflächenschicht (106) ferner wenigstens zwei entgegengesetzte zweite laterale Ränder (130) freilegt, die durch den Teil der Region (110) aus verspanntem Halbleiter gebildet und im Wesentlichen orthogonal zu den zwei ersten lateralen Rändern (118) sind;
- der Schritt des Modifizierens derart durchgeführt wird, dass er wenigstens vier erste Bereich (120) aus verspanntem Halbleiter freilegt, die die zwei ersten lateralen Ränder (118) und die zwei zweiten lateralen Ränder (130) bilden und die in Kontakt mit der vergrabenen dielektrischen Schicht (104) sind.

14. Verfahren nach einem der vorhergehenden Ansprüche, bei dem die Ätzmaske (114) wenigstens ein zug- oder kompressionsverspanntes Material umfasst.

15. Verfahren nach einem der vorhergehenden Ansprüche, ferner umfassend nach dem Entfernen der Ätzmaske (114) die Durchführung der folgenden Schritte:
- Abdünnen der Region (110) aus verspanntem Halbbleiter;
- Epitaxie von wenigstens einem zweiten Halbleiter (154) auf der abgedünnten Region (110) aus verspanntem Halbleiter.

16. Verfahren zum Realisieren wenigstens eines FET-Transistors (126), bei dem der wenigstens eine FET-Transistor (126) in der Region (110) aus verspanntem Halbleiter eines Halbleitersubstrats (100) realisiert wird, erhalten durch die Durchführung des Verfahrens nach einem der vorhergehenden Ansprüche.

## Claims

1. Method for producing a semiconductor substrate (100), including at least the implementation of the following steps:
- producing a superficial layer (106) arranged on a buried dielectric layer (104) and including at least one strained semiconductor region (110);
- producing an etching mask (114) on the superficial layer (106), covering at least one part of said at least one strained semiconductor region (110);
- etching the superficial layer (106) according to a pattern of the etching mask (114), exposing at least one first lateral edge (118) formed by at least one first strained semiconductor portion (120) belonging to said part of said strained semiconductor region (110) and which is in contact with the buried dielectric layer (104);
- modifying the first strained semiconductor portion (120) into at least one second portion (121) of material forming a mechanical support element arranged against the strained semiconductor region (110);
- removing the etching mask (114).

2. Method according to claim 1, wherein the step of modifying the first strained semiconductor portion (120) comprises the implementation of a chemical reaction transforming the strained semiconductor.

3. Method according to claim 2, wherein the chemical reaction corresponds to an oxidation and/or a nitridation of the strained semiconductor.

4. Method according to one of claims 2 and 3, wherein the step of modifying the first strained semiconductor portion (120) further comprises, prior to the implementation of the chemical reaction of the strained semiconductor, a step of removing a part of the first strained semiconductor portion (120), and wherein the chemical reaction is next implemented from the remainder of the first strained semiconductor portion (120).

5. Method according to claim 1, wherein the step of modifying the first strained semiconductor portion (120) comprises:
- an etching of the first strained semiconductor portion (120), forming at least one cavity (136) arranged between the buried dielectric layer (104) and the etching mask (114), then
- a step of producing, in the cavity (136), the second portion (121) of material.

6. Method according to one of previous claims, wherein the material of the second portion corresponds to at least one semiconductor material and/or one dielectric material.

7. Method according to one of previous claims, wherein the strained semiconductor corresponds to compressively strained SiGe, and wherein the superficial layer (106) is produced by germanium enrichment in a silicon layer.

8. Method according to one of previous claims, wherein the pattern of the etching mask (114) defines isolation trenches (116) arranged around the strained semiconductor region (110), and wherein the method further comprises, after the step of modifying the first strained semiconductor portion (120), a step of depositing at least one dielectric material (124) in the isolation trenches (116).

9. Method according to claim 8, further comprising, between the step of modifying the first strained semiconductor portion (120) and the step of removing the hard mask (114), the implementation of an etching step extending the isolation trenches (116) through at least one part of the thickness of the buried dielectric layer (104), or through the buried dielectric layer (104) and a part of the thickness of a support layer (102) arranged such that the buried dielectric layer (104) is arranged between the support layer (102) and the superficial layer (106).

10. Method according to one of previous claims, wherein a dimension of the first strained semiconductor portion (120), along a direction substantially perpendicular to the first lateral edge (118), is between around 3 nm and 25 nm.

11. Method according to one of previous claims, wherein the step of etching the superficial layer (106) etches the pattern of the etching mask (114) through the superficial layer (106), or through the superficial layer (106) and at least one part of the thickness of the buried dielectric layer (104), or through the superficial layer (106), the buried dielectric layer (104) and a part of the thickness of a support layer (102) arranged such that the buried dielectric layer (104) is arranged between the support layer (102) and the superficial layer (106).

12. Method according to one of previous claims, wherein:
- the strained semiconductor region (110) has, in a main plane of the superficial layer (106), a substantially rectangular shape;
- the pattern of the etching mask (114) is such that the etching of the superficial layer (106) exposes at least two opposite first lateral edges (118) formed by the part of the strained semiconductor region (110);
- the step of modification is implemented such that it modifies at least two first strained semiconductor portions (120) that form the two first lateral edges (118) and which are in contact with the buried dielectric layer (104).

13. Method according to claim 12, wherein:
- the pattern of the etching mask (114) is such that the etching of the superficial layer (106) further exposes at least two opposite second lateral edges (130), formed by the part of the strained semiconductor region (110) and substantially perpendicular to the two first lateral edges (118);
- the step of modification is implemented such that it modifies at least four first strained semiconductor portions (120) that form the two first lateral edges (118) and the two second lateral edges (130) and which are in contact with the buried dielectric layer (104).

14. Method according to one of previous claims, wherein the etching mask (114) comprises at least one tensile or compressively strained material.

15. Method according to one of previous claims, further comprising, after the removal of the etching mask (114), the implementation of the following steps:
- thinning of the strained semiconductor region (110);
- epitaxy of at least one second semiconductor (154) on the strained semiconductor region (110) which is thinned.

16. Method for producing at least one FET transistor (126), wherein said at least one FET transistor (126) is produced in the strained semiconductor region (110) of a semiconductor substrate (100) obtained by the implementation of the method according to one of previous claims.
